# EUROPÄISCHE PATENTSCHRIFT

(11) **EP 0 508 951 B1**
(45) Veröffentlichungstag und Bekanntmachung des Hinweises auf die Patenterteilung: **21.08.1996**
(21) Anmeldenummer: 92810237.5
(22) Anmeldetag: 31.03.1992
(51) Int. Cl.: C08G 59/68

(54) **Thermisch härtbare Zusammensetzungen**
Heat curable composition
Composition thermodurcissable

(30) Priorität: 08.04.1991 CH 1029/91
(43) Veröffentlichungstag der Anmeldung: 14.10.1992
(73) Patentinhaber: CIBA-GEIGY AG, 4002 Basel (CH)
(72) Erfinder: Baumann, Dieter, CH-4313 Möhlin (CH); Margotte, Werner, CH-4419 Lupsingen (CH); Müller, Beat, Dr., CH-1723 Marly (CH)

(56) Entgegenhaltungen:
- EP-A- 0 379 464
- US-A- 3 677 978
- US-A- 4 473 674
- US-A- 4 554 342
- DATABASE WPI Week 8704, Derwent Publications Ltd., London, GB; AN 87-026302

## Beschreibung

Die Erfindung betrifft die Verwendung eines Inhibitors für die kationische Polymerisation als Zusatz zu einer thermisch härtbaren Zusammensetzung auf Basis mindestens eines kationisch polymerisierbaren organischen Materials und eines Initiators für die kationische Polymerisation in Form einer Oniumverbindung oder einer Verbindung der Formel (I)

[M⁺ⁿ(L)ₓ]ⁿ⁺n X⁻ (I),

worin n gleich 2 oder 3 ist, M ein Metallkation ausgewählt aus der Gruppe bestehend aus Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ und Co³⁺ darstellt, X⁻ ein Anion ist, das ausgewählt wird aus der Gruppe bestehend aus PF₆⁻, AsF₆⁻, SbF₆⁻, BiF₆⁻, von diesen Anionen abgeleiteten Derivaten, worin zumindest ein Fluoratom durch eine Hydroxylgruppe ersetzt ist, und CF₃SO₃⁻, oder worin bis zu 50 % der Anionen X⁻, bezogen auf die Gesamtmenge der Anionen, auch beliebige Anionen sein können, L Wasser oder ein organischer σ-Donorligand ist, der als Ligandenstellen ein oder mehrere funktionelle Reste ausgewählt aus der Gruppe bestehend aus -CO-, -CO-O-, -O-CO-O- oder -O- aufweist, und der über das Sauerstoffatom oder über die Sauerstoffatome mit dem Zentralatom σ-Bindungen ausbildet und x eine ganze Zahl von 0 bis 6 bedeutet, und wobei die Liganden L im Rahmen der gegebenen Definitionen unterschiedlich sein können, oder als Zusatz zu Komponenten für die Herstellung einer derartigen Zusammensetzung. Die Erfindung betrifft weiterhin entsprechende Zusammensetzungen, ein Verfahren zur Herstellung der beschriebenen Zusammensetzungen sowie ihre bevorzugten Verwendungen.

Kationisch härtbare Zusammensetzungen mit Oniumsalzen als Initiatorverbindungen, z. B. organischen Phosphonium-, Ammonium- , Halonium- und insbesondere Sulfoniumsalzen, sind vielfach beschrieben worden und werden heute für die unterschiedlichsten Zwecke, beispielsweise in flüssiger Form als Giessmassen oder in fester Form als Pressmassen eingesetzt.

Ebenso sind kationisch härtbare Zusammensetzungen mit Initiatorverbindungen der oben genannten Formel (I) bereits bekannt. Sie sind in der EP-A-0 388 837 beschrieben.

Die genannten Zusammensetzungen weisen jedoch noch Nachteile auf.

So startet die Härtungsreaktion häufig nach längerer und/oder unsachgemässer, insbesondere zu feuchter Lagerung bereits bei Temperaturen, die gegenüber denen, die für gleichartige, aber aus frischen Komponenten hergestellte Zusammensetzungen gemessen werden, wesentlich erniedrigt sind. Das gilt insbesondere für lösungsmittelhaltige Zusammensetzungen, auch bei Anwendung des Zweikomponentenprinzips, wenn die Härterkomponente den Initiator in gelöster oder dispergierter Form enthält. Weiterhin tritt nach langer Lagerung der Härterkomponente oftmals gleich nach dem Vermischen von Härter- und Monomerkomponente ein starker Viskositätsanstieg auf, auch wenn die Zusammensetzungen keiner oder nur einer mässigen Temperaturbelastung ausgesetzt und beispielsweise bei Raumtemperatur gehandhabt werden. Dieser Viskositätsanstieg kann das Auffüllen von feinstrukturierten Gussformen mit solchen Zusammensetzungen sehr erschweren oder sogar unmöglich machen.

Oftmals wäre es auch wünschenswert, wenn die Zusammensetzungen während der Herstellung oder der Applikation kurzzeitig auf relativ hohe Temperaturen erhitzt werden könnten, ohne dass hierdurch bereits die Härtung gestartet würde.

Manche kationisch polymerisierbaren Materialien beispielsweise können nämlich nicht oder nur unter Verwendung grosser Mengen von Verdünnungsmitteln, welche vielfach jedoch die Eigenschaften des gehärteten Materials in unerwünschter Weise beeinflussen, für Giessanwendungen benützt werden, weil das Material bei Temperaturen, die unterhalb einer Temperatur liegen, bei der bereits nach kurzer Zeit eine merkliche Härtung einsetzt, noch viel zu viskos wäre, um die Zusammensetzungen sauber vergiessen zu können.

Auch bei der Herstellung von festen Zusammensetzungen des eingangs genannten Typs, wie z.B. von Pulverlackgemischen, kann zu frühes Einsetzen der Härtungsreaktion zu Problemen führen. Die hierbei für eine spätere gleichmässige Aushärtung erforderliche homogene Vermischung des Initiators mit dem festen polymerisierbaren Material wird in der Regel nämlich ebenfalls bei erhöhter Temperatur mit Hilfe einer Schmelzhomogenisierung der Komponenten erreicht. Bei zahlreichen der eingangs genannten Initiatorverbindungen ist es aber nicht möglich, eine wirklich gute und homogene Einarbeitung des Initiators in das feste kationisch polymerisierbare Material mit dieser weitverbreiteten Technik zu erreichen, da bereits vor Ablauf der zur Homogenisierung erforderlichen Zeit auch in diesem Fall die Härtung der Masse einsetzen würde.

In beiden vorgenannten Fällen soll aber selbstverständlich die für die spätere Härtung der Zusammensetzung erforderliche Temperatur nicht oder zumindest nicht in wesentlichem Ausmass ansteigen.

Es hat sich nunmehr gezeigt, dass sich die thermische Härtungsreaktion einer Zusammensetzung auf Basis von kationisch polymerisierbarem Material und Polymerisationsinitiatoren in Form von Oniumverbindungen oder Verbindungen der obigen Formel (I) durch Zugabe geeigneter Mengen eines Polymerisationsinhibitors so steuern lässt, dass Stabilitätsprobleme, wie die oben genannten, nicht auftreten. Durch die Verwendung eines Polymerisationsinhibitors als Zusatz zu den genannten Zusammensetzungen können nämlich insbesondere feuchtigkeitsbedingte Zersetzungsprodukte des Initiators in einer Weise umgesetzt werden, dass sie die Verarbeitung und den Härtungsverlauf der Zusammensetzungen nicht mehr beeinflussen. Weiterhin kann auf diese Weise die thermische Stabilität der Zusammensetzungen zeitlich begrenzt erhöht werden.

Die vorliegende Erfindung betrifft daher die Verwendung eines Inhibitors für die kationische Polymerisation als Zusatz zu einer thermisch härtbaren Zusammensetzung auf Basis mindestens eines kationisch polymerisierbaren organischen Materials und eines Initiators für die kationische Polymerisation in Form einer Oniumverbindung oder einer Verbindung der Formel (I)

[M⁺ⁿ(L)ₓ]ⁿ⁺ n X⁻ (I),

worin n gleich 2 oder 3 ist, M ein Metallkation ausgewählt aus der Gruppe bestehend aus Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ und Co³⁺ darstellt, X⁻ ein Anion ist, das ausgewählt wird aus der Gruppe bestehend aus PF₆⁻, AsF₆⁻, SbF₆⁻, BiF₆⁻, von diesen Anionen abgeleiteten Derivaten, worin zumindest ein Fluoratom durch eine Hydroxylgruppe ersetzt ist, und CF₃SO₃⁻, oder worin bis zu 50 % der Anionen X⁻, bezogen auf die Gesamtmenge der Anionen, auch beliebige Anionen sein können, L Wasser oder ein organischer σ-Donorligand ist, der als Ligandenstellen ein oder mehrere funktionelle Reste ausgewählt aus der Gruppe bestehend aus -CO-, -CO-O-, -O-CO-O- oder -O- aufweist, und der über das Sauerstoffatom oder über die Sauerstoffatome mit dem Zentralatom σ-Bindungen ausbildet und x eine ganze Zahl von 0 bis 6 bedeutet, und wobei die Liganden L im Rahmen der gegebenen Definitionen unterschiedlich sein können, oder als Zusatz zu Komponenten für die Herstellung einer derartigen Zusammensetzung zur Vermeidung feuchtigkeitsbedingter, die thermische Stabilität der Zusammensetzung senkender Zersetzungsprodukte des Initiators und/oder zu einer Erhöhung der thermischen Stabilität der Zusammensetzung, die auf einen Zeitbereich vor der Härtung begrenzt ist.

Ein weiterer Gegenstand der vorliegenden Erfindung ist eine thermisch härtbare Zusammensetzung, die mindestens folgende Komponenten enthält:
a) ein kationisch polymerisierbares organisches Material,
b) einen Initiator für die kationische Polymerisation in Form einer Oniumverbindung oder einer Verbindung der Formel (I)

   [M⁺ⁿ(L)ₓ]ⁿ⁺ n X⁻ (I),

   worin n gleich 2 oder 3 ist, M ein Metallkation ausgewählt aus der Gruppe bestehend aus Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ und Co³⁺ darstellt, X⁻ ein Anion ist, das ausgewählt wird aus der Gruppe bestehend aus PF₆⁻, AsF₆⁻, SbF₆⁻, BiF₆⁻, von diesen Anionen abgeleiteten Derivaten, worin zumindest ein Fluoratom durch eine Hydroxylgruppe ersetzt ist, und CF₃SO₃⁻, oder worin bis zu 50 % der Anionen X-, bezogen auf die Gesamtmenge der Anionen, auch beliebige Anionen sein können, L Wasser oder ein organischer σ-Donorligand ist, der als Ligandenstellen ein oder mehrere funktionelle Reste ausgewählt aus der Gruppe bestehend aus -CO-, -CO-O-, -O-CO-O- oder -O- aufweist, und der über das Sauerstoffatom oder über die Sauerstoffatome mit dem Zentralatom σ-Bindungen ausbildet und x eine ganze Zahl von 0 bis 6 bedeutet, und wobei die Liganden L im Rahmen der gegebenen Definitionen unterschiedlich sein können,
c) einen Polymerisationsinhibitor in einer so geringen Menge, dass genügend von ihm unbeeinflusster Initiator b) verbleibt, um die erwünschte Härtung der Zusammensetzung durchzuführen.

Als Polymerisationsinhibitoren sind im allgemeinen Verbindungen geeignet, die stärker nukleophil sind als das verwendete kationisch polymerisierbare Material und mit den Protonen in der Zusammensetzung oder mit den Kationen der wachsenden Polymerkette rascher reagieren als die Monomeren des verwendeten polymerisierbaren Materials, so dass Protonen und Kationen keine Polymerisation dieses Materials mehr initiieren können.

Als Polymerisationsinhibitoren kann man insbesondere Basen verwenden, die die starken Brønstedtsäuren, die von den Initiatorverbindungen bei der thermischen Härtung, aber auch während der Lagerung durch Zersetzung aufgrund von Feuchtigkeit oder Verunreinigungen, z. B. im Lösungs- oder Dispersionsmittel der Initiatorkomponente, gebildet werden, im Sinne einer Säure/Base-Reaktion neutralisieren. Da es sich bei den genannten Brønstedtsäuren allgemein um sehr starke Säuren, wie HSbF₆ oder HPF₆, handelt, sind hierbei auch viele Verbindungen als Base einsetzbar, die in Wasser an sich eine saure Reaktion zeigen, wie beispielsweise Tetrabutylammoniumhydrogensulfat. Bevorzugt sind Basen, deren Stärke einem pKa-Wert von etwa 2 bis etwa 12 (bei 25 °C in Wasser) entspricht. Beispiele für derartige Basen können leicht den üblichen Tabellenwerken der Chemie entnommen werden, beispielsweise Lange's Handbook of Chemistry (Editor John A. Dean), 13^{th} Ed. (1985), McGraw-Hill Book Company, New York, Section 5, Tables 5-6 and 5-7. Die erfindungsgemäss eingesetzten Basen können fest sein, wie basische Füllstoffe, z. B. ungewaschenes Aluminiumoxidtrihydrat. Die Basen können aber auch flüssig sein, wie beispielsweise viele Amine.

Amine sind eine erfindungsgemäss besonders bevorzugte Gruppe von Polymerisationsinhibitoren. Bevorzugt sollen diese Amine einen pKa-Wert von 2 bis 9 (25 °C in Wasser) zeigen. In Frage kommen sowohl primäre, sekundäre wie auch tertiäre Amine. Ausserdem sollen hier unter dem Begriff "Amin" auch Heterocyclen verstanden werden, in denen der Aminstickstoff ein Glied des Heterocyclus ist, z. B. Pyrazole, Imidazole, Pyrrolidine, Pyrroline, Imidazolidine, Imidazoline, Pyrazolidin, Pyrazoline, Piperidine, Piperazine, Indoline, Morpholine, Chinuclidin, 1,8-Diazabicyclo[5.4.0]undec-7-en, 1,5-Diazabicyclo[4.3.0]non-5-en oder 1,4-Diazabicyclo[2.2.2]octan.

Besonders bevorzugt sind sekundäre und insbesondere tertiäre Amine, hiervon wiederum Tribenzylamin, 1-Methylimidazol, 1,8-Diazabicyclo[5.4.0]undec-7-en, 1,5-Diazabicyclo[4.3.0]non-5-en und 1,4-Diazabicyclo[2.2.2]octan.

Für die Erfindung besonders gut geeignet sind Amine, ausgewählt aus der Gruppe: (c₁) aromatische Amine mit einer bis vier NH₂-Gruppen mit mindestens einem Substituenten in ortho-Stellung zu jeder Aminogruppe, wobei der Substituent C₁-C₁₀-Alkyl, C₁-C₁₀-Alkoxy,C₅-C₆-Cycloalkyl, C₆-C₁₀-Aryl oder Halogen bedeutet, mit der Massgabe, dass das Amin nicht in beiden ortho-Stellungen zu einer Aminogruppe durch Halogen substituiert ist, und

(c₂) aromatische Amine mit einer bis 4 NH₂-Gruppen mit einem ortho- oder para-Substituenten zu jeder vorhandenen Aminogruppe, wobei der Substituent -COOH, -COOR, -COR, -SO₂R oder -SOR bedeutet und R für C₁-C₁₀-Alkyl, C₅-C₆-Cycloalkyl, C₆-C₁₀-Aryl, Aminoaryl oder -R′-OOC-C₆H₄-NH₂ mit R′ gleich Alkylen steht.

Derartige Verbindungen mit 2, 3 oder 4 NH₂-Gruppen können z.B. durch Kondensation eines entsprechend substituierten Anilins mit Aldehyden oder Ketonen, z.B. mit Formaldehyd [Untergruppe (c₁)] oder durch Umsetzung einer Aminosäure mit Verbindungen, die 2-4 zur Esterkondensation befähigte OH-Gruppen besitzen, [Untergruppe (c₂)] hergestellt werden.

Die aromatischen Amine der Untergruppen (c₁) und (c₂) können einkernig oder zweikernig sein. Die zweikernigen Verbindungen können sowohl kondensierte als auch unkondensierte Ringe enthalten.

Die Alkylsubstituenten bzw. die Alkylgruppen der Alkoxysubstituenten der Amine der Untergruppe (c₁) können geradkettig oder verzweigt sein. Beispiele geeigneter Alkylgruppen sind Methyl, Ethyl, n- und Isopropyl Butyl, Pentyl, Hexyl, Octyl oder Decyl, Beispiele geeigneter Alkoxygruppen sind die den genannten Alkylgruppen entsprechenden Alkoxyreste. Beispiele geeigneter Cycloalkylgruppen sind Cyclopentyl oder Cyclohexyl. Beispiele geeigneter Arylgruppen sind Phenyl oder Naphthyl. Geeignete Halogensubstituenten sind Iod, Brom und insbesondere Chlor.

Bevorzugte Amine der Untergruppe (c₁) haben eine oder zwei NH₂-Gruppen und einen pKa-Wert von 3-4,5 und weisen mindestens einen Alkylsubstituenten in ortho-Stellung zu jeder Aminogruppe auf. Besonders bevorzugte Amine der Untergruppe (c₁) sind 2,6-Dialkylaniline oder Verbindungen der Formel (II) 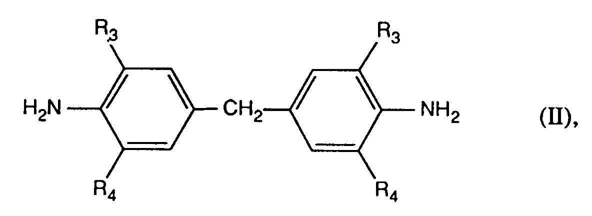 worin R₃ Chlor oder C₁-C₃-Alkyl und R₄ Wasserstoff oder C₁-C₃-Alkyl bedeuten, insbesondere 2,6-Diisopropylanilin oder Verbindungen der Formel (II), worin R₃ und R₄ unabhängig voneinander C₁-C₃-Alkyl, vorzugsweise Ethyl oder Isopropyl, bedeuten.

Beispiele besonders geeigneter Amine der Gruppe (c₁) sind 2,6-Diisopropylanilin,
3-Amino-2,4-diethyl-6-methylanilin, Bis(4-amino-3,5-diethylphenyl)methan,
Bis(4-amino-3-methyl-5-isopropylphenyl)methan,
Bis(4-amino-3,5-diisopropylphenyl)methan, Bis(4-amino-3-ethyl-5-methylphenyl)methan,
Bis(4-amino-3,5-diethylphenyl)methan, Bis(4-amino-3-methylphenyl)methan und
Bis(4-amino-3-chlorphenyl)methan.

Bei den ortho- oder para-Substituenten relativ zur Aminogruppe der Untergruppe (c₂) handelt es sich um elektronenziehende Gruppen.

Falls der Rest R gemäss Definition der Amine (c₂) C₁-C₁₀-Alkyl, C₅-C₆-Cycloalkyl oder C₆-C₁₀-Aryl bedeutet, gilt für diesen Rest das weiter oben für die entsprechenden Substituenten der Amine der Untergruppe (c₁) ausgeführte.

Wenn R Aminoaryl bedeutet, handelt es sich bevorzugt um ein Aminoaryl mit 6 bis 10 Ringkohlenstoffatomen, z.B. um Aminonaphthyl oder Aminophenyl, wie 1-Amino-4-naphthyl, 2-Amino-6-naphthyl, 2-Amino-6-naphthyl, oder 2-, 3- und insbesondere 4-Aminophenyl.

Falls R für eine Gruppe -R′-OOC-C₆H₄NH₂ steht, bedeutet R' vorzugsweise C₂-C₁₀-Alkylen und die Aminogruppe ist vorzugsweise in para-Stellung am Phenylring.

Bevorzugte Amine aus der Untergruppe (c₂) sind Verbindungen mit einer oder zwei NH₂-Gruppen und einem pKa-Wert von 2-3,5. Beispiele bevorzugter Verbindungen sind Anthranilsäure oder Verbindungen der Formel (III) 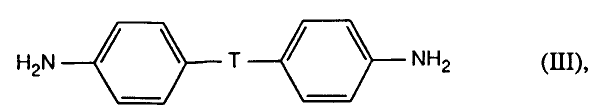 worin T für CO, SO und insbesondere für SO₂ oder -COO(CH₂)ₘOOC- mit m = 2-6, vorzugsweise m = 2, steht.

Geeignet sind zum Beispiel 4-Aminobenzoesäure, Anthranilsäure, Bis(4-aminophenyl)sulfon, Bis(4-aminophenyl)sulfoxid, Bis(4-aminophenyl)keton oder 1,3-Propandiolbis(4-aminobenzoat).

Amine können als solche in der härtbaren Zusammensetzung enthalten sein oder können auch mit einem Epoxidharz vorreagiert werden. Diese Vorreaktion erfolgt vorzugsweise bei erhöhter Temperatur, z.B. bei 100-200°C. Die vorgenannte Variante der Erfindung kann z. B. zweckmässig sein, wenn als kationisch polymerisierbares Material ein Epoxidharz eingesetzt wird. Ausführungsformen der Erfindung sind aber bevorzugt, bei der Amine ohne Vorreaktion mit einem Epoxidharz eingesetzt werden.

Der Polymerisationsinhibitor c) darf erfindungsgemäss nur in einer Menge eingesetzt werden, die so gering ist, dass ein Überschuss an Initiator in der Zusammensetzung enthalten ist, der ausreichend für die Härtung der Masse ist. Der Überschuss an Initiator sollte bevorzugt zumindest bei 0,05 - 5 Gew.-%, bezogen auf das kationisch polymerisierbare Material liegen, kann aber auch höher sein. Werden übliche Mengen Initiator verwendet, wird man den Inhibitor in einer Menge einsetzen, die erheblich unter der Menge liegt, die den freien Kationen oder Säureprotonen äquivalent ist, die der Initiator bilden kann. So kann der Polymerisationsinhibitor z. B. in einer Menge von 0,01 bis 0,5 Äquivalenten, bezogen auf einen Initiator der Formel (I) bzw. auf die Oniumgruppen eines Oniuminitiators, verwendet werden und wird besonders zweckmässig in einer Menge von 0,01 bis 0,15 Äquivalenten eingesetzt.

Als Komponente a) der erfindungsgemässen Zusammensetzungen sind alle üblichen kationisch polymerisierbaren organischen Materialien geeignet, beispielsweise die nachfolgend angeführten, wobei diese für sich allein oder als Gemische von mindestens zwei Komponenten eingesetzt werden können:

I. Ethylenisch ungesättigte Verbindungen, die nach einem kationischen Mechanismus polymerisierbar sind. Dazu gehören
1. Mono- und Diolefine, z.B. Isobutylen, Butadien, Isopren, Styrol, α-Methylstyrol, Divinylbenzole, N-Vinylpyrrolidon, N-Vinylcarbazol und Acrolein.
2. Vinylether, z.B. Methylvinylether, Isobutylvinylether, Trimethylolpropantrivinylether, Ethylenglykoldivinylether, cyclische Vinylether, z.B. 3,4-Dihydro-2-formyl-2H-pyran (dimeres Acrolein) und der 3,4-Dihydro-2H-pyran-2-carbonsäureester des 2-Hydroxymethyl-3,4-dihydro-2H-pyrans.
3. Vinylester, z.B. Vinylacetat und Vinylstearat.

II. Kationisch polymerisierbare heterocyclische Verbindungen, z.B. Ethylenoxyd, Propylenoxyd, Epichlorhydrin, Glycidylether einwertiger Alkohole oder Phenole, z.B. n-Butylglycidylether, n-Octylglycidylether, Phenylglycidylether und Kresylglycidylether, Glycidylacrylat, Glycidylmethacrylat, Styroloxyd und Cyclohexenoxyd; Oxetane, wie 3,3-Dimethyloxetan und 3,3-Di-(chlormethyl)-oxetan; Tetrahydrofuran; Dioxolane, Trioxan und 1,3,6-Trioxacyclooctan; Lactone, wie β-Propiolacton, γ-Valerolacton und ε-Caprolacton; Thiirane, wie Ethylensulfid und Propylensulfid; Epoxidharze; lineare und verzweigte Polymere mit Glycidylgruppen in den Seitenketten, z.B. Homo- und Copolymere von Polyacrylat- und Polymethacrylat-glycidylestern.

Besonders wichtige unter diesen obengenannten polymerisierbaren Verbindungen sind die Epoxidharze, insbesondere die di- und polyfunktionellen Epoxide, und Epoxidharzpräpolymere der zur Herstellung vernetzter Epoxiharze verwendeten Art. Die Di- und Polyepoxide können aliphatische, cycloaliphatische oder aromatische Verbindungen sein. Beispiele für solche Verbindungen sind die Glycidylether und β-Methylglycidylether aliphatischer oder cycloaliphatischer Diole oder Polyole, zum Beispiel solche des Ethylenglykols, Propan- 1,2-diols, Propan- 1,3-diols, Butan- 1,4-diols, Diethylenglykols, Polyethylenglykols, Polypropylenglykols, Glycerins, Trimethylolpropans oder 1,4-Dimethylolcyclohexans oder des 2,2-Bis-(4-hydroxycyclohexyl)-propans, die Glycidylether von Di- und Polyphenolen, beispielsweise Resorcin, 4,4′-Dihydroxydiphenylmethan, 4,4′-Dihydroxydiphenyl-2,2-propan, Novolake und 1, 1,2,2-Tetrakis-(4-hydroxyphenyl)-ethan.

Weitere Glycidylverbindungen mit technischer Bedeutung sind die Glycidylester von Carbonsäuren, insbesondere Di- und Polycarbonsäuren. Beispiele dafür sind die Glycidylester der Bernsteinsäure, Adipinsäure, Azelainsäure, Sebacinsäure, Phthalsäure, Terephthalsäure, Tetra- und Hexahydrophthalsäure, Isophthalsäure oder Trimellitsäure, oder von dimerisierten Fettsäuren.

Beispiele für von Glycidylverbindungen verschiedene Polyepoxide sind die Diepoxide des Vinylcyclohexens und Dicyclopentadiens, 3-(3′,4′-Epoxicyclohexyl)-8,9-epoxy-2,4-dioxaspiro[5.5]undecan, der 3′,4′-Epoxicyclohexylmethylester der 3,4-Epoxicyclohexancarbonsäure, Butadiendiepoxid oder Isoprendiepoxid, epoxidierte Linolsäurederivate oder epoxidiertes Polybutadien.

Bevorzugte Epoxidharze sind gegebenenfalls vorverlängerte Diglycidylether zweiwertiger Phenole oder zweiwertiger aliphatischer Alkohole mit 2 bis 4 Kohlenstoffatomen. Bevorzugt sind die Epoxidharze unterhalb der Temperatur, bei der die Härtung einsetzt, fliessfähig. Ganz besonders bevorzugt werden die gegebenenfalls vorverlängerten Diglycidylether des 2,2-Bis-(4-hydroxyphenyl)-propans und Bis-(4-hydroxyphenyl)-methans oder ein Gemisch aus diesen Epoxidharzen.

Als kationisch polymerisierbare Verbindungen kommen ferner in Betracht:

### Phenoplaste.

Bevorzugte Phenoplaste sind aus einem Phenol und einem Aldehyd hergestellte Resole. Zu geeigneten Phenolen gehören Phenol selbst, Resorcin, 2,2-Bis-(p-hydroxyphenyl)-propan, p-Chlorphenol, ein durch eine oder zwei Alkylgruppen mit je 1 bis 9 Kohlenstoffatomen substituiertes Phenol, wie o-, m- und p-Kresol, die Xylenole, p-tert.-Butylphenol und p-Nonylphenol sowie auch phenylsubstituierte Phenole, insbesondere p-Phenylphenol. Der mit dem Phenol kondensierte Aldehyd ist vorzugsweise Formaldehyd, doch kommen auch andere Aldehyde, wie Acetaldehyd und Furfural, in Frage. Gewünschtenfalls kann man ein Gemisch solcher härtbaren Phenol/Aldehydharze verwenden.

Bevorzugte Resole sind Kondensationsprodukte des Phenols, p-Chlorphenols, Resorcins oder o-, m- oder p-Kresols mit Formaldehyd.

Als Oniuminitiatoren für die kationische Polymerisation können gemäss der vorliegenden Erfindung ebenfalls alle üblicherweise für diesen Zweck bekannten Verbindungen verwendet werden. Es handelt sich hierbei bekanntlich um salzartige Verbindungen, die ein oder mehrere kationische Zentren in Form von koordinativ abgesättigten Atomen der fünften, Sechsten oder siebten Hauptgruppe des Periodensystems und Gegenanionen möglichst geringer Nucleophilie aufweisen, z. B. um entsprechende Ammonium-, Phosphonium-, Sulfonium-, Sulfoxonium, Selenium-, Iodonium- oder Bromoniumverbindungen. Das kationische Zentrum der Verbindungen kann dabei auch Teil eines cyclischen Strukturelementes der Initiatorverbindung sein. Oniuminitiatoren, wie die genannten, sind in der Literatur bereits vielfach beschrieben worden. Als Beispiele sei hier auf die folgenden Dokumente verwiesen, ohne dass damit eine Einschränkung auf die speziell in diesen Dokumenten beschriebenen Typen von Oniuminitatoren vorgenommen werden soll: US-A-4,058,400; US-A-4,058,401; US-A-4,069,055; US-A-5,013,814; PCT-Anmeldung WO 90/11303; japanische Patentanmeldungen JP 58037003 A2 und JP 58037004 A2.

Polymerisationsinitiatoren wie die der Formel (I) sind in der EP-A-0 388 837 beschrieben, auf die hier ebenfalls ausdrücklich verwiesen wird. Die Erläuterungen, die in diesem Dokument zu Bevorzugungen der Formel (I) gegeben sind, gelten auch für die vorliegende Erfindung.

Erfindungsgemässe Zusammensetzungen, die als Komponente b) einen Sulfoniumsalzinitiator mit einer oder mehreren Sulfoniumsalzgruppen im Molekül enthalten, sind im allgemeinen bevorzugt. Dies gilt besonders für thermisch härtbare Zusammensetzungen, die als Initiatoren Mono-, Di- oder Tris(arylalkyl)sulfoniumverbindungen enthalten, wobei als Arylalkyl -gegebenenfalls unterschiedliche- Reste der Formel Ar-CH₂- bevorzugt sind, worin Ar z. B. ein unsubstituiertes oder durch C₁-C₈-Alkyl, durch Alkoxy, insbesondere C₁-C₄-Alkoxy, Halogen, Hydroxy, Nitro, Phenyl, Phenoxy, Alkoxycarbonyl, insbesondere mit 1-4 C-Atomen im Alkoxyrest, oder Acyl mit 1-12 C-Atomen einfach oder mehrfach substituiertes Phenyl oder Naphthyl bedeutet, und die übrigen Reste am Sulfoniumschwefel unabhängig voneinander z. B. C₁-C₁₂-Alkyl-, C₃-C₈-Cycloalkyl-, C₄-C₁₀-Cycloalkylalkyl-, unsubstituierte oder durch C₁-C₈-Alkyl, Alkoxy, insbesondere C₁-C₄-Alkoxy, Halogen, Hydroxy, Nitro, Phenyl, Phenoxy, Alkoxycarbonyl, insbesondere mit 1-4 C-Atomen im Alkoxyrest, oder Acyl mit 1-12 C-Atomen einfach oder mehrfach substituierte Phenylreste sind. Als wenig nukleophile Gegenanionen eignen sich z. B. Anionen des Aufbaus Z(Hal)ₖ mit unterschiedlicher negativer Ladung, worin Z für ein Metall oder Metalloid- steht, Hal Halogen, insbesondere Fluor oder Chlor bedeutet und k eine ganze Zahl von 4 bis 6 ist. Beispiele sind BF₄⁻, PF₆⁻, AsF₆⁻, SbF₆⁻, BiCl₅⁻ etc. Eines oder mehrere der Halogenatome dieses Anionentyps können auch durch Hydroxidgruppen ersetzt sein. Ein Beispiel für diese Anionen ist SbF₅(OH)⁻. Ebenfalls als Anionen geeignet sind fluorierte, insbesondere perfluorierte Alkylsulfonatanionen, wie CF₃SO₃⁻. Ganz besonders bevorzugte Anionen sind SbF₆⁻, AsF₆⁻ und SbF₅(OH)⁻.

Zusammensetzungen mit Sulfoniuminitiatoren der Formel (IV), (V), (VI) oder (VII) zeigen besonders gute Eigenschaften: 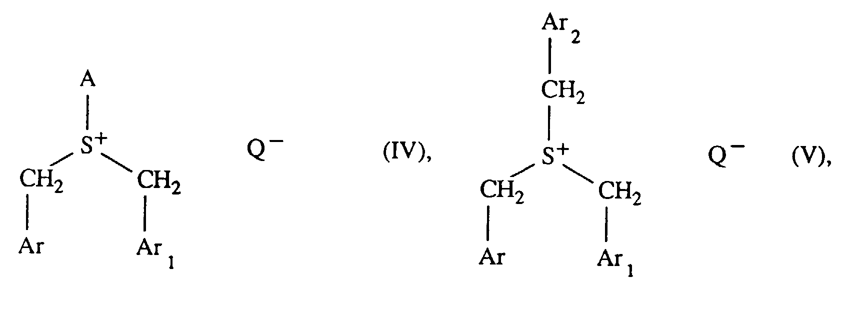 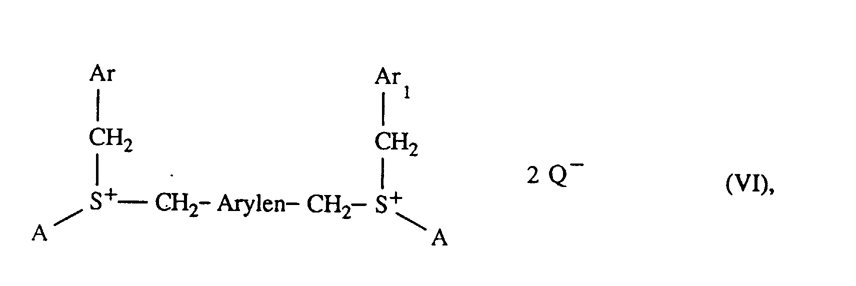 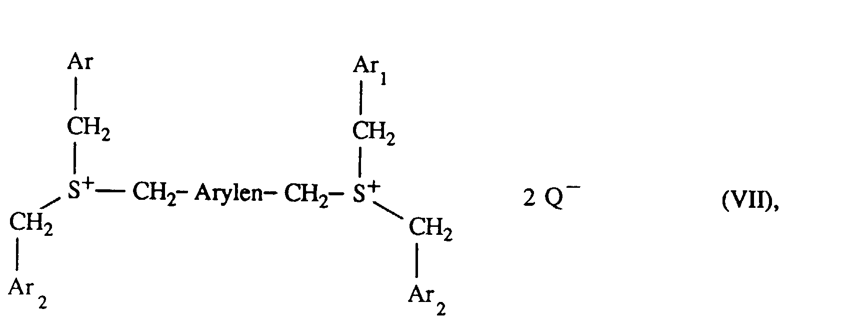 wobei A für ein C₁-C₁₂-Alkyl, C₃-C₈-Cycloalkyl, C₄-C₁₀-Cycloalkylalkyl, unsubstituiertes oder durch C₁-C₈-Alkyl, C₁-C₄-Alkoxy, Halogen, Hydroxy, Nitro, Phenyl, Phenoxy, Alkoxycarbonyl mit 1-4 C-Atomen im Alkoxyrest oder Acyl mit 1-12 C-Atomen einfach oder mehrfach substituiertes Phenyl steht, Ar, Ar₁ und Ar₂ unabhängig voneinander je ein unsubstituiertes oder durch C₁-C₈-Alkyl, C₁-C₄-Alkoxy, Halogen, Hydroxy, Nitro, Phenyl, Phenoxy, Alkoxycarbonyl mit 1-4 C-Atomen im Alkoxyrest oder Acyl mit 1-12 C-Atomen einfach oder mehrfach substituiertes Phenyl oder Naphthyl bedeuten, Arylen je ein unsubstituiertes oder durch C₁-C₈-Alkyl, C₁-C₄-Alkoxy, Halogen, Hydroxy, Nitro, Phenyl, Phenoxy, Alkoxycarbonyl mit 1-4 C-Atomen im Alkoxyrest oder Acyl mit 1-12 C-Atomen einfach oder mehrfach substituiertes Phenylen oder Naphthylen bedeutet und Q⁻ für SbF₆⁻, AsF₆⁻ oder SbF₅OH⁻ steht.

Hiervon sind wiederum die Zusammensetzungen mit Sulfoniuminitiatoren der Formel (IV) oder (V) besonders bevorzugt, worin A ein C₁-C₁₂-Alkyl oder ein unsubstituiertes oder durch Halogen oder C₁-C₄-Alkyl substituiertes Phenyl bedeutet, Ar, Ar₁ und Ar₂ unabhängig voneinander je ein unsubtituiertes oder durch C₁-C₈-Alkyl, C₁-C₄-Alkoxy, Cl oder Br einfach oder mehrfach substituiertes Phenyl bedeuten und Q⁻ für SbF₅OH⁻ oder insbesondere für AsF₆⁻ oder SbF₆⁻ steht. Für die Erfindung ganz besonders bevorzugt werden die Dibenzylphenylsulfoniumsalze.

Die Menge an Initiatorverbindung beträgt im allgemeinen 0,05 bis 20 Gew.-%, bezogen auf das kationisch polymerisierbare organische Material, bevorzugt 1 bis 15, insbesondere 1 - 5 Gew.-%.

Bei einer speziellen Ausführungsform der Erfindung enthalten die Zusammensetzungen als weitere Komponente d) ein inertes Lösungs- oder Dispersionsmittel für den Härtungsinitiator. Bevorzugte Lösungsmittel sind die Diester aromatischer Dicarbonsäuren, insbesondere Dibutylphthalat.

Gegebenenfalls können in den erfindungsgemässen Zusammensetzungen, insbesondere wenn als kationisch polymerisierbare Verbindung ein Epoxidharz enthalten ist, noch weitere thermische Härtungsmittel, wie zum Beispiel Polycarbonsäuren, Polycarbonsäureanhydride oder Polyphenole, enthalten sein, welche die kationische Härtung mit Sulfoniumsalzen nicht stören. Der Anteil eines solchen Härtungsmittels ist kleiner als die für die vollständige Aushärtung des kationisch polymerisierbaren organischen Materials erforderliche stöchiometrische Menge des weiteren Härtungsmittels.

Ausserdem können die erfindungsgemässen Zusammensetzungen noch weitere mit dem verwendeten kationisch polymerisierbaren organischen Material copolymerisierbare Verbindungen, wie beispielsweise cyclische Ether oder cyclische Lactone enthalten, wie ε-Caprolacton, γ-Butyrolacton oder Tetrahydrofurfurylalkohol. Im Falle der Verwendung von copolymerisierbaren Verbindungen beträgt deren Anteil im allgemeinen zwischen 1 bis 50 Gew.%, bezogen auf die Menge an verwendetem kationisch polymerisierbarem organischen Material, und die Menge des Härtungskatalysators im allgemeinen 0,05 bis 20 Gew.-%, bezogen auf die Menge an verwendetem kationisch polymerisierbarem organischen Material und die Menge der copolymerisierbaren Verbindung.

Die Zusammensetzungen können auch bekannte und üblicherweise in der Technik polymerisierbarer Materialien eingesetzte Zusatzstoffe enthalten. Beispiele für solche Zusatzstoffe sind Coinitiatoren, z. B. sekundäre oder tertiäre Diole, Pigmente, Farbstoffe, Füllstoffe, wie Talkum, Kaolin, Glimmer, Gips, Titandioxid, Quarzmehl, Cellulose, Tonerde, gemahlener Dolomit, Wollastonit, Kieselerde mit grosser spezifischer Oberfläche (Areosil®), gepulvertes Polyvinylchlorid, Polyolefine sowie Metallpulver, wie Kupfer-, Silber-, Aluminium- oder Eisenpulver, Verstärkungsmittel, Glasfasern und sonstige Fasern, Flammhemmstoffe, wie Antimontrioxid, und Antistatika, Verlaufmittel, Antioxydantien und Lichtschutzmittel.

Ein Zusatz von Aluminiumoxidtrihydrat zu den erfindungsgemässen Zusammensetzungen, bevorzugt in einer Menge von 50 bis 70 Gew.-%, bezogen auf die gesamte Zusammensetzung, hat eine überraschend gute Flammhemmung bei den Zusammensetzungen zur Folge. Entsprechende Zusammensetzungen bilden daher ebenfalls einen Gegenstand der Erfindung. Das Aluminiumoxidtrihydrat muss aber so weit alkalifrei sein, dass die Härtung der Masse nicht behindert wird.

Die Polymerisationsinhibitoren können jederzeit vor dem Zusammenbringen der Initiatorkomponente mit dem polymerisierbaren Material, auch unmittelbar davor, zugesetzt werden. Sie reagieren praktisch sofort mit den hierbei in die Zusammensetzung eingebrachten oder auch danach gebildeten Zersetzungsprodukten des Initiators ab, so dass die Zersetzungsprodukte keine Wirkung als nicht latenter Härter für das polymerisierbare Material haben.

Manche Polymerisationsinhibitoren bewirken zusätzlich eine Erhöhung der Temperatur, die für den Start der Härtung erforderlich ist. Dies ist gleichbedeutend mit einer Steigerung der thermischen Stabilität der Zusammensetzung. Beispiele für solche Inhibitoren sind Tribenzylamin, Bis(4-amino-3-ethyl-5-methylphenyl)methan 1,8-Diazabicyclo [5.4.0]undec-7-en oder 1,5-Diazabicyclo [4.3.0]non-5-en, die den Effekt insbesondere bei Verwendung von Sulfoniuminitiatoren zeigen. Mit Hilfe von DSC-Messungen können derartige Stoffe leicht aufgrund der Verschiebung des Beginns des Härtungspeaks zu höheren Temperaturen aufgefunden werden, den diese Zusammensetzungen im Vergleich zu gleichartigen Zusammensetzungen ohne den Inhibitor zeigen. Die genannten Zusammensetzungen können bei höherer Temperatur als entsprechende inhibitorfreie Zusammensetzungen verarbeitet werden und bei einer gegebenen Temperatur wesentlich länger gehandhabt werden als die letzteren. Setzt man einer bestimmten Zusammensetzung Inhibitoren des genannten Typs in steigendem Ausmass zu, so kann man in allgemeinen eine immer stärkere Erhöhung der zum Start der Härtung erforderlichen Temperatur erreichen. So wird es möglich, die thermische Stabilität der Zusammensetzungen in weitem Rahmen zu steuern. Da der Inhibitor aber nur zu einem Anteil in den erfindungsgemässen Zusammensetzungen enthalten ist, der einem Bruchteil des insgesamt vorhandenen Initiators äquivalent ist, und praktisch vollständig abreagiert, bevor eine Reaktion des polymerisierbaren Materials eintritt, wird die eigentliche Härtung der Zusammensetzung, die schliesslich vom überschüssigen Initiator hervorgerufen wird, durch den Zusatz des Inhibitors nicht mehr beeinflusst. Im DSC-Diagramm zeigt sich dies daran, dass das Exothermiemaximum der Härtungsreaktion nicht oder nicht wesentlich verschoben ist.

Beispiele für Polymerisationinhibitoren, die den zuvor geschilderten Effekt nicht oder nur in minimalem Ausmass zeigen, sind 1-Methylimidazol, 1.4-Diazabicyclo[2.2.2]octan, 3-Amino-2,4-diethyl-6-methylanilin.

Die zeitweilige Steigerung der thermischen Stabilität durch die erfindungsgemässe Verwendung von Polymerisationsinhibitoren kann selbstverständlich auch dann vorteilhaft sein, wenn die in Rede stehenden Zusammensetzungen frisch hergestellt werden und ihre Lagerung nicht geplant oder auch unproblematischer ist, wie im Falle fester Zusammensetzungen. So kann die vorliegende Erfindung z. B. vorteilhaft bei der Herstellung von Faserverbundstoffen angewendet werden. Hierbei ermöglichen nämlich erfindungsgemässe Zusammensetzungen gefahrlos eine zeitlich begrenzte höhere Erhitzung der Matrixharze während der Applikation, was geringere Viskositäten und damit eine bessere Durchdringung des Fasermaterials mit der Matrix bewirkt oder z. B. die Verwendung von weniger oder gar keinem Verdünnungs- bzw. Lösungsmittel in der Zusammensetzung erlaubt. Ebenso können höher erhitzte und somit weniger viskose Giessharze das Füllen von Gussformen, die komplizierte und feine Strukturen aufweisen, erheblich erleichtern. Genauso lässt sich die thermische Homogenisierung fester Einkomponentensysteme, beispielsweise von Pulverlackgemischen oder heisshärtenden festen Klebstoffmassen, mit thermisch stabileren Zusammensetzungen besser und sicherer bewerkstelligen, wie schon in der Einleitung dargelegt wurde.

Bei Anwendung der vorliegenden Erfindung auf Zweikomponentenzusammensetzungen, d. h. bei getrennter Herstellung und Lagerung der Komponente, die den Initiator enthält, und der Komponente, die das kationisch polymerisierbare organische Material enthält, wird der Polymerisationsinhibitor zweckmässig der Komponente mit dem polymerisierbaren Material zugesetzt. Die Menge an Polymerisationsinhibitor in dieser Teilkomponente kann variieren, wird aber im allgemeinen zwischen 0,01 und 5 Gew.-%, bezogen auf den Harz, liegen. Zur Härtung muss Initiator in einer solchen Menge zu dieser Teilkomponente gegeben werden, dass ein Überschuss von Initiator gegenüber der Menge an Inhibitor in der fertigen Zusammensetzung enthalten ist, der ausreichend für die Härtung der Masse ist.

Weiterhin betrifft die Erfindung auch ein Verfahren zur Herstellung einer erfindungsgemässen Zusammensetzung, bei dem
A) zumindest ein Initiator für die kationische Polymerisation in Form einer Oniumverbindung oder einer Verbindung der Formel (I) mit einem für ihn geeigneten Lösungs- oder Dispersionsmittel homogen vermischt wird,
B) zumindest ein Polymerisationsinhibitor, wie oben beschrieben, als Komponente c) mit dem kationisch polymerisierbaren organischen Material homogen vermischt wird,
C) die in den Schritten A) und/oder B) erhaltenen Teilmischungen gegebenenfalls zwischengelagert werden, und
D) die beiden Teilmischungen miteinander vermischt werden.

Zusätzlich können einer lösungsmittelhaltigen Initiatorkomponente gegebenenfalls noch Molekularsiebmaterialien, speziell Zeolithe, zugesetzt werden, da sie die Desaktivierung des Initiators durch Zersetzung verlangsamen können, indem sie u. a. das Restwasser in dieser Komponente absorbieren. Die Lagerfähigkeit des Härters kann auf diese Weise zusätzlich erhöht werden. Das Zeolithmaterial weist bevorzugt eine Korngrösse von etwa 3 bis 5 µm und eine Porengrösse von 0,3 bis 0,7 nm auf und kann z. B. in einer Menge von 0,1 bis 20 Gew.-%, insbesondere 0,1 bis 10 Gew.-%, bezogen auf den Härtungsinitiator, verwendet werden.

Die erfindungsgemässen Zusammensetzungen lassen sich prinzipiell in beliebiger Form erhalten, z.B. als homogene flüssige Gemische oder in homogener oder inhomogener glasiger Form. Homogene glasige Produkte können in an sich bekannter Weise zum Beispiel durch Verflüssigung fester kationisch polymerisierbarer organischer Materialien, gegebenenfalls unter Zusatz geeigneter Lösungsmittel, Erhitzen auf Temperaturen über ihren Glasumwandlungspunkt, Zugabe von Inhibitor und Initiator und Abkühlung der entstandenen Gemische erhalten werden.

Die erfindungsgemässen Gemische können bei relativ niedrigen Temperaturen rasch ausgehärtet werden. Bevorzugt sind Zusammensetzungen, die bei Temperaturen zwischen 45 und 150 °C ausgehärtet werden können. Das Exothermiemaximum der Härtungsreaktion der Zusammensetzungen liegt bevorzugt unter 140, noch besser unter 130 °C. Ganz besonders bevorzugt soll es bei höchstens 115 °C liegen. Das Exothermiemaximum kann in üblicher Weise z. B. mit Hilfe eines Differential-Scanning-Kalorimeters bestimmt werden. Man kann an den erfindungsgemässen Gemischen auch erst eine Vorhärtung bei tieferen Temperaturen bis zum Gelieren der härtbaren Zusammensetzung durchführen, an die sich dann eine Aushärtung bei höheren Temperaturen anschliesst.

Die Aushärtung erfolgt in der Regel unter gleichzeitiger Formgebung zu Formkörpern, Imprägnierungen, Beschichtungen oder Verklebungen.

Die erfindungsgemässen Zusammensetzungen lassen sich ganz allgemein zur Herstellung von gehärteten Produkten einsetzen, und können in der dem jeweils speziellen Anwendungsgebiet angepassten Formulierung, beispielsweise als Beschichtungsmassen, Lacke, auch Pulverlacke, Pressmassen, Tauchharze, Giessharze, Imprägnierharze, Laminierharze, 1- oder 2-Komponenten-Klebstoffe oder Matrixharze, insbesondere zur Umhüllung oder Impregnierung von Gegenständen, eingesetzt werden.

Die Verwendung von thermisch härtbaren erfindungsgemässen Zusammensetzungen, auch in Form einer Niederdruckmasse, zur Imprägnierung und/oder Umhüllung von Gegenständen, insbesondere von elektrischen Hoch- oder Niederspannungsbauteilen oder von elektronischen Bauteilen, ist besonders bevorzugt und bildet daher ebenfalls einen Gegenstand der Erfindung.

Weitere Gegenstände der Erfindung bilden die Verwendung erfindungsgemässer Zusammensetzungen als flüssige oder feste Beschichtungsmittel, z. B. als Lack- bzw. Pulverlackmischungen, die Verwendung zur Herstellung von Epoxidniederdruckpressmassen (Low Pressure Molding Compounds), die Verwendung der Zusammensetzungen als Teil von Composite-Systemen für Leiterplatten oder als Matrix für Faserverbundstoffe und schliesslich die Verwendung der beschriebenen Zusammensetzungen als heisshärtende Klebstoffe.

Die aus den erfindungsgemässen Gemischen durch thermische Härtung erhaltenen Produkte zeichnen sich durch eine hohe Temperaturbeständigkeit aus und stellen feste, unlösliche und unschmelzbare, dreidimensional vernetzte Produkte dar.

### Beispiel 1:

0,011 Gewichtsteile 1-Methylimidazol werden bei Raumtemperatur in 36 Gewichtsteilen eines Gemisches aus Bisphenol-A- und Bisphenol-F-diglycidyletherharzen gelöst. Anschliessend erfölgt bei gleichen Bedingungen das Einhomogenisieren von 0,4 Teilen Glycidoxypropyltrimethoxysilan (SILAN® 187 A) und portionsweise zugegebenem Quarz (Novacite® 1250). Zu dieser Harzformulierung gibt man eine Härterlösung bestehend aus 3,2 Gewichtsteilen Dibutylphthalat und 0,4 Gewichtsteilen des bei 70 °C in Lösung gehenden Dibenzylphenylsulfoniumhexafluoroantimonat. Eine derartige Masse besitzt bei Raumtemperatur eine Topfzeit von mehreren Stunden. Eine entsprechende Mischung ohne 1-Methylimidazol besitzt eine wesentlich kürzere Topfzeit.

### Beispiele 2 bis 9:

Jeweils 10 Mol% des angegebenen Inhibitors, bezogen auf die in der Zusammensetzung vorhandene Katalysatormenge werden einem Epoxidharz, basierend auf einem Gemisch aus Bisphenol-A und Bisphenol-F mit einer Viskosität von 6500 - 8000 mPa·s (bei 25 °C nach DIN 53015) und einem Epoxidäquivalent von 172 - 182 g/Eq (ARALDIT® PY 302⁻²) zugesetzt. Als Härter wird 9 Gewichtsteilen des Harzes ein Gewichtsteil einer Lösung von 10 Gew.-% Dibenzylphenylsulfoniumhexafluoroantimonat in Dibutylphthalat zugegeben. Dem DSC-Diagramm können die in der folgenden Tabelle angegebenen Temperaturen für den Beginn der (exothermen) Härtungsreaktion und für das Exothermie-Maximum sowie für die Gesamtenergie entnommen werden.

| Inhibitor | Beginn der Härtung [°C] | Exothermie-Maximum [°C] | Gesamtenergie [J/g] |
|---|---|---|---|
| Tribenzylamin | 90 | 98 | 534 |
| Bis(4-amino-3-ethyl-5-methylphenyl)methan | 80 | 98 | 534 |
| 1,8-Diazabicyclo-[5.4.0]undec-7-en | 77 | 98 | 528 |
| 1,5-Diazabicyclo-[4.3.0]non-5-en | 75 | 99 | 536 |
| 1-Methylimidazol | 65 | 98 | 530 |
| 1,4-Diazabicyclo-[2.2.2]octan | 60 | 98 | 538 |
| 3-Amino-2,4-diethyl-6-methylanilin | 63 | 94 | 541 |
| Tetrabutylammoniumhydrogensulfat | 82,4 | 101,8 | 502 |

Die Härtung beginnt jeweils scharf bei der angegebenen Temperatur. Während einer mehrstündigen Topfzeit bei Raumtemperatur ist keine vorzeitige Härtung oder ein Ansteigen der Viskosität der Zusammensetzungen feststellbar. Die Beispiele machen ausserdem deutlich, dass die Temperatur, bei der die Härtung beginnt, bei Verwendung unterschiedlicher Polymerisationsinhibitoren bei ansonsten gleicher Zusammensetzung gesteuert werden kann.

### Beispiele 10 bis 12:

Einem Epoxidharz, basierend auf einem Gemisch aus Bisphenol-A und Bisphenol-F mit einer Viskosität von 6500 - 8000 mPa·s (bei 25 °C nach DIN 53015) und einem Epoxidäquivalent von 172 - 182 g/Eq (ARALDIT® PY 302⁻²) werden jeweils 17,3 mg 1-Methylimidazol pro 100 g Harz als Inhibitor zugesetzt. Als Härter wird 9 Gewichtsteilen des Harzes ein Teil einer Lösung von 10 Gew.-% des angegebenen Initiators in Dibutylphthalat zugegeben. Dem DSC-Diagramm können die in der folgenden Tabelle angegebenen Eigenschaften entnommen werden.

| Initiator | Beginn der Härtung [°C] | Exothermie-Maximum [°C] | Gesamtenergie [J/g] |
|---|---|---|---|
| Dibenzylphenylsulfoniumhexafluoroantimonat | 65 | 98 | 524 |
| Benzylethylphenylsulfoniumhexafluoroantimonat | 83 | 119 | 497 |
| Tris-(pentamethylbenzyl)-sulfoniumhexafluoroantimonat | 61 | 77 | 512 |

Die Härtung beginnt jeweils scharf bei der angegebenen Temperatur. Während einer mehrstündigen Topfzeit bei Raumtemperatur ist keine vorzeitige Härtung oder ein Ansteigen der Viskosität der Zusammensetzungen feststellbar.

### Beispiele 13 bis 19:

Es wird eine Harzkomponente folgender Zusammensetzung hergestellt:
- 37,36 Gew.-%: ARALDIT® PY 302⁻² (Epoxidharz, basierend auf einem Gemisch aus Bisphenol-A und Bisphenol-F mit einer Viskosität von 6500 - 8000 mPa·s (bei 25 °C nach DIN 53015) und einem Epoxidäquivalent von 172 - 182 g/Eq
- 0,01 Gew.-%: 1-Methylimidazol
- 0,31 Gew.-%: SILAN® 187 A (Glycidoxypropyltrimethoxysilan)
- 0,05 Gew.-%: eines üblichen siliconfreien Entlüfters
- 0,10 Gew.-%: BENTONE® SD2 (organisch modifizierter Montmorrillonit)
- 62,17 Gew.-%: APYRAL® 2E (Aluminiumoxidtrihydrat)

Die in der folgenden Tabelle angegebenen Initiatoren werden in Dibutylphthalat (DBPh) in der jeweils angegebenen Konzentration gelöst bzw. dispergiert. Jeweils 3,78 Gewichtsteile dieser Lösung werden mit 100 Teilen der oben angeführten Harzkomponente gemischt. Dem DSC-Diagramm können die in der folgenden Tabelle angegebenen Werte entnommen werden.

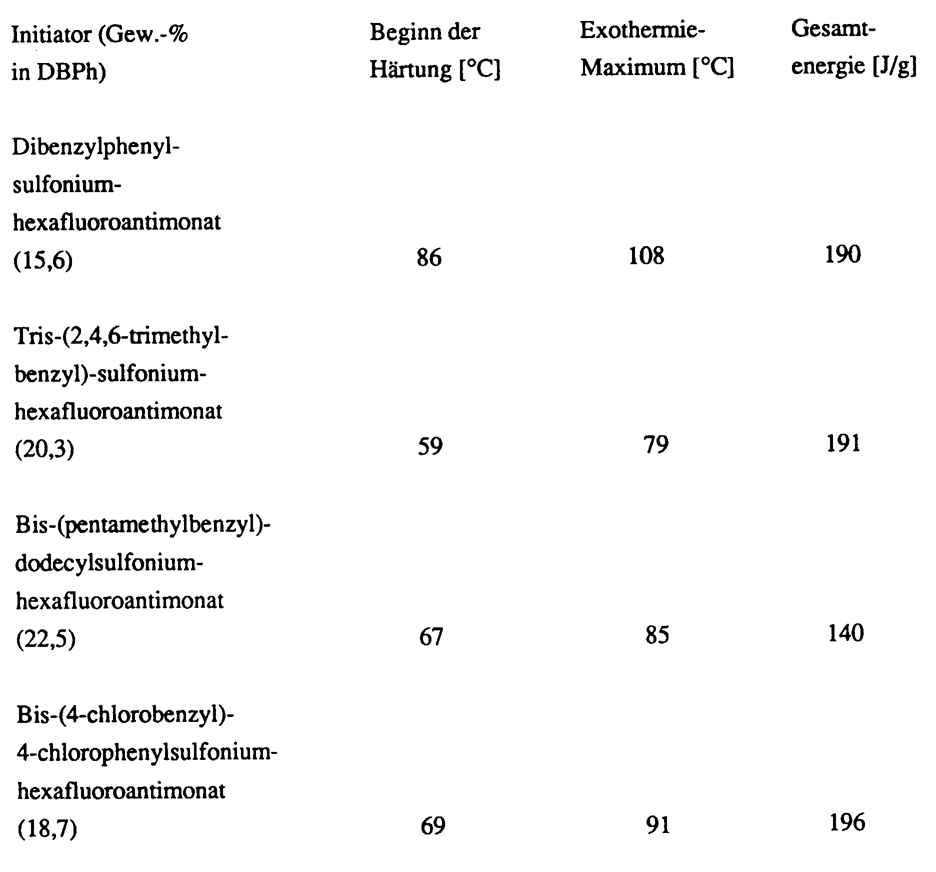

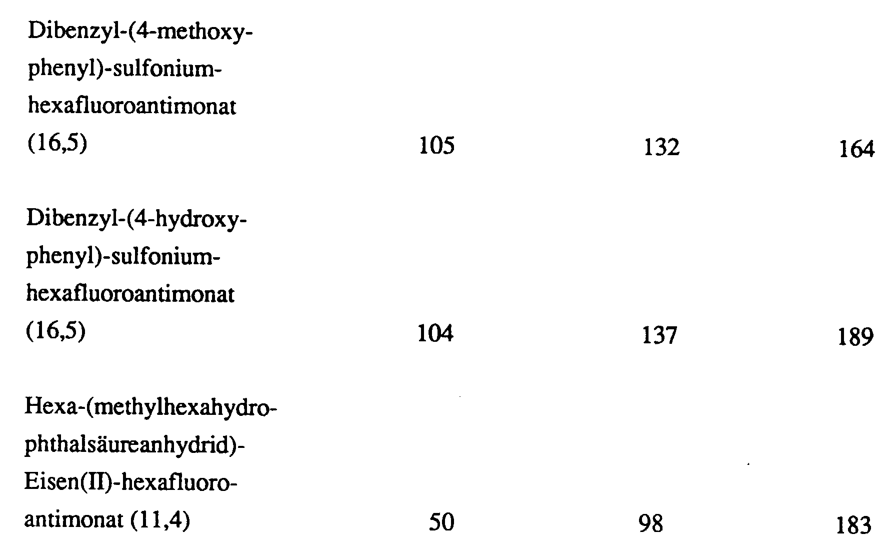

### Beispiele 20 - 22:

Eine Harzkomponente wird aus dem in der folgenden Tabelle angegebenen kationisch polymerisierbaren Material und 1-Methylimidazol (17,3 mg/100g polymerisierbarem Material) hergestellt. 9 Gewichtsteile der Harzkomponente werden jeweils mit einem Gewichtsteil der Härterkomponente (10%ige Lösung von Dibenzylphenylsulfoniumhexafluoroantimonat in Dibutylphthalat) vermischt. Dem DSC-Diagramm können die in der folgenden Tabelle angegebenen Temperaturen für den Beginn der (exothermen) Härtungsreaktion, für das Exothermie-Maximum und die Gesamtenergie der Härtungsreaktion entnommen werden.

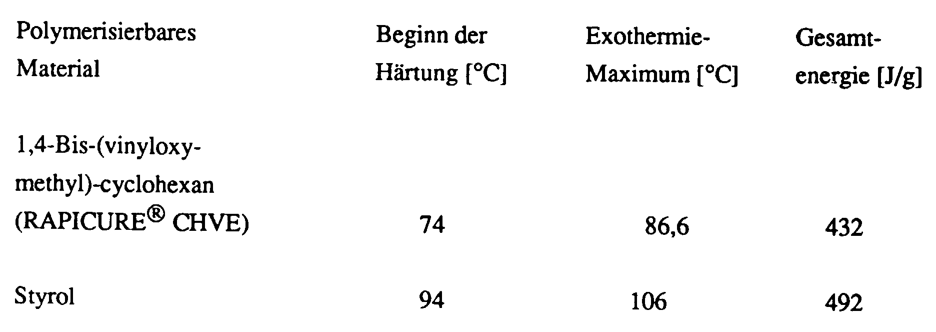

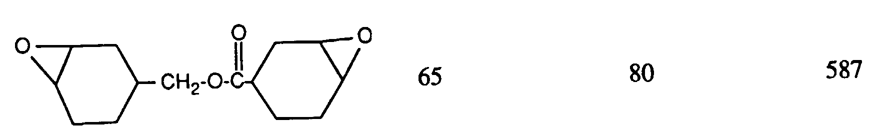

### Beispiele 23, 24:

Eine Zusammensetzung aus 1 Gew.-% des in der folgenden Tabelle jeweils angegebenen Initiators, der angegebenen Menge Tribenzylamin und eines festen Epoxidharzpulvers, ARALDIT® GT 7004 (Erweichungspunkt 95 - 101 °C; Epoxidäquivalent 715 - 750 g/Eq), als Rest wird mit einem Mixer fein gepulvert und vermischt. Dem DSC-Diagramm können die in der folgenden Tabelle angegebenen Temperaturen für den Beginn der (exothermen) Härtungsreaktion, für das Exothermie-Maximum und die Gesamtenergie entnommen werden.

| Initiator/Gew.-% Tribenzylamin | Beginn der Härtung [°C] | Exothermie-Maximum [°C] | Gesamtenergie [J/g] |
|---|---|---|---|
| Dibenzylphenylsulfoniumhexafluoroantimonat/0,1 | 95 | 114 | 90 |
| Tris-(4-methylbenzyl)-sulfoniumhexafluoroantimonat/0,05 | 118 | 137 | 120 |

## Patentansprüche

1. Verwendung eines Inhibitors für die kationische Polymerisation als Zusatz zu einer thermisch härtbaren Zusammensetzung auf Basis mindestens eines kationisch polymerisierbaren organischen Materials und eines Initiators für die kationische Polymerisation in Form einer Oniumverbindung oder einer Verbindung der Formel (I)
[M⁺ⁿ(L)ₓ]ⁿ⁺ n X⁻ (I),
worin n gleich 2 oder 3 ist, M ein Metallkation ausgewählt aus der Gruppe bestehend aus Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ und Co³⁺ darstellt, X⁻ ein Anion ist, das ausgewählt wird aus der Gruppe bestehend aus PF₆⁻, AsF₆⁻, SbF₆⁻, BiF₆⁻, von diesen Anionen abgeleiteten Derivaten, worin zumindest ein Fluoratom durch eine Hydroxylgruppe ersetzt ist, und CF₃SO₃⁻, oder worin bis zu 50 % der Anionen X⁻, bezogen auf die Gesamtmenge der Anionen, auch beliebige Anionen sein können, L Wasser oder ein organischer σ-Donorligand ist, der als Ligandenstellen ein oder mehrere funktionelle Reste ausgewählt aus der Gruppe bestehend aus -CO-, -CO-O-, -O-CO-O- oder -O- aufweist, und der über das Sauerstoffatom oder über die Sauerstoffatome mit dem Zentralatom σ-Bindungen ausbildet und x eine ganze Zahl von 0 bis 6 bedeutet, und wobei die Liganden L im Rahmen der gegebenen Definitionen unterschiedlich sein können, oder als Zusatz zu Komponenten für die Herstellung einer derartigen Zusammensetzung zur Vermeidung feuchtigkeitsbedingter, die thermische Stabilität der Zusammensetzung senkender Zersetzungsprodukte des Initiators und/oder zu einer Erhöhung der thermischen Stabilität der Zusammensetzung, die auf einen Zeitbereich vor der Härtung begrenzt ist.

2. Thermisch härtbare Zusammensetzung, die mindestens folgende Komponenten enthält:
a) ein kationisch polymerisierbares organisches Material,
b) einen Initiator für die kationische Polymerisation in Form einer Oniumverbindung oder einer Verbindung der Formel (I)
[M⁺ⁿ(L)ₓ]ⁿ⁺ n X⁻ (I),
worin n gleich 2 oder 3 ist, M ein Metallkation ausgewählt aus der Gruppe bestehend aus Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ und Co³⁺ darstellt, X⁻ ein Anion ist, das ausgewählt wird aus der Gruppe bestehend aus PF₆⁻, AsF₆⁻, SbF₆⁻, BiF₆⁻, von diesen Anionen abgeleiteten Derivaten, worin zumindest ein Fluoratom durch eine Hydroxylgruppe ersetzt ist, und CF₃SO₃⁻, oder worin bis zu 50 % der Anionen X⁻, bezogen auf die Gesamtmenge der Anionen, auch beliebige Anionen sein können, L Wasser oder ein organischer σ-Donorligand ist, der als Ligandenstellen ein oder mehrere funktionelle Reste ausgewählt aus der Gruppe bestehend aus -CO-, -CO-O-, -O-CO-O- oder -O- aufweist, und der über das Sauerstoffatom oder über die Sauerstoffatome mit dem Zentralatom σ-Bindungen ausbildet und x eine ganze Zahl von 0 bis 6 bedeutet, und wobei die Liganden L im Rahmen der gegebenen Definitionen unterschiedlich sein können,
c) einen Polymerisationsinhibitor der die starken Brønstedtsäuren, die von den Initiatorverbindungen bei der thermischen Härtung, aber auch während der Lagerung durch Zersetzung aufgrund von Feuchtigkeit oder Verunreinigungen, gebildet werden, im Sinn einer Säure/Base-Reaktion neutraliziert, in einer so geringen Menge, dass genügend von ihm unbeeinflusster Initiator b) verbleibt, um die erwünschte Härtung der Zusammensetzung durchzuführen.

3. Zusammensetzung nach Anspruch 2, wobei als Komponente c) ein Brønstedtbase zugesetzt wird, deren Stärke einem pKa-Wert von 2 bis 12 (bei 25 °C in Wasser) entspricht.

4. Zusammensetzung nach Anspruch 2, die als Komponente c) ein Amin enthält.

5. Zusammensetzung nach Anspruch 4, die ein tertiäres Amin enthält.

6. Zusammensetzung nach Anspruch 4, die ein Amin enthält, ausgewählt aus der Gruppe:
(c₁) aromatische Amine mit einer bis vier NH₂-Gruppen mit mindestens einem Substituenten in ortho-Stellung zu jeder Aminogruppe, wobei der Substituent C₁-C₁₀-Alkyl, C₁-C₁₀-Alkoxy, C₅-C₆-Cycloalkyl, C₆-C₁₀-Aryl oder Halogen bedeutet, mit der Massgabe, dass das Amin nicht in beiden ortho-Stellungen zu einer Aminogruppe durch Halogen substituiert ist,
(c₂) aromatische Amine mit einer bis 4 NH₂-Gruppen mit einem ortho- oder para-Substituenten zu jeder vorhandenen Aminogruppe, wobei der Substituent -COOH, -COOR, -COR, -SO₂R oder -SOR bedeutet und R für C₁-C₁₀-Alkyl, C₅-C₆-Cycloalkyl, C₆-C₁₀-Aryl Aminoaryl oder -R′-OOC-C₆H₄-NH₂ mit R′ gleich Alkylen steht.

7. Zusammensetzung nach Anspruch 4, bei der das Amin einen pKa-Wert von 2 bis 9 zeigt.

8. Zusammensetzung nach Anspruch 2, bei der der Polymerisationsinhibitor in einer Menge von 0,01 bis 0,5, bevorzugt 0,01 bis 0,15 Äquivalenten, bezogen auf die Oniumgruppen im Initiator, vorhanden ist.

9. Zusammensetzung nach Anspruch 2 die als Komponente a) ein di- oder polyfunktionelles Epoxidharz enthält.

10. Zusammensetzung nach Anspruch 2, die als Komponente b) einen Sulfoniumsalzinitiator enthält.

11. Zusammensetzung nach Anspruch 10, die als Sulfoniumsalzinitiator eine Verbindung der Formel (IV), (V), (VI) oder (VII) enthält: 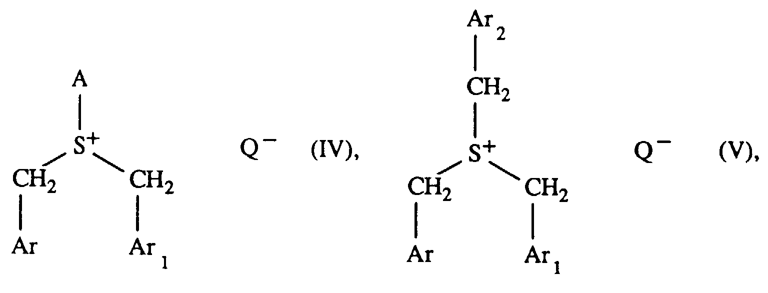 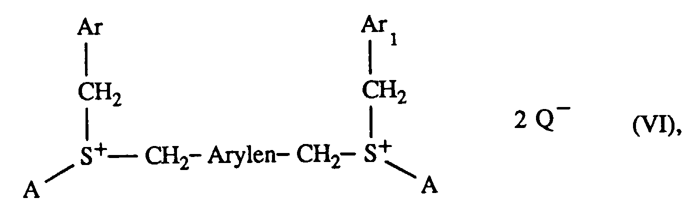 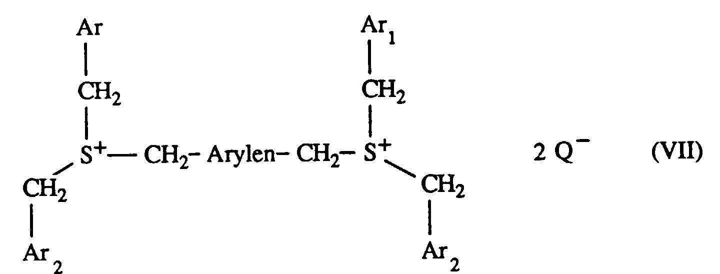 worin A für ein C₁-C₁₂-Alkyl, C₃-C₈-Cycloalkyl, C₄-C₁₀-Cycloalkylalkyl, unsubstituiertes oder durch C₁-C₈-Alkyl, C₁-C₄-Alkoxy, Halogen, Hydroxy, Nitro, Phenyl, Phenoxy, Alkoxycarbonyl mit 1-4 C-Atomen im Alkoxyrest oder Acyl mit 1-12 C-Atomen einfach oder mehrfach substituiertes Phenyl steht, Ar, Ar₁ und Ar₂ unabhängig voneinander je ein unsubstituiertes oder durch C₁-C₈-Alkyl, C₁-C₄-Alkoxy, Halogen, Hydroxy, Nitro, Phenyl, Phenoxy, Alkoxycarbonyl mit 1-4 C-Atomen im Alkoxyrest oder Acyl mit 1-12 C-Atomen einfach oder mehrfach substituiertes Phenyl oder Naphthyl bedeuten, Arylen je ein unsubstituiertes oder durch C₁-C₈-Alkyl, C₁-C₄-Alkoxy, Halogen, Hydroxy, Nitro, Phenyl, Phenoxy, Alkoxycarbonyl mit 1-4 C-Atomen im Alkoxyrest oder Acyl mit 1-12 C-Atomen einfach oder mehrfach substituiertes Phenylen oder Naphthylen bedeutet und Q⁻ für SbF₆⁻, AsF₆⁻ oder SbF₅OH⁻ steht.

12. Zusammensetzung nach Anspruch 11, die als Komponente b) einen Sulfoniuminitiator der Formel (IV) oder (V) enthält, worin A ein C₁-C₁₂-Alkyl oder ein unsubstituiertes oder durch Halogen oder C₁-C₄-Alkyl substituiertes Phenyl bedeutet, Ar, Ar₁ und Ar₂ unabhängig voneinander je ein unsubtituiertes oder durch C₁-C₈-Alkyl, C₁-C₄-Alkoxy, Cl oder Br einfach oder mehrfach substituiertes Phenyl bedeuten und Q⁻ für SbF₅OH⁻ oder insbesondere für AsF₆⁻ oder SbF₆⁻ steht.

13. Zusammensetzung nach Anspruch 2, die als weitere Komponente d) ein Lösungs- oder Dispersionsmittel für den Initiator enthält.

14. Zusammensetzung nach Anspruch 2, die Aluminiumoxidhydrat in einer Menge von 50 bis 70 Gew.-%, bezogen auf die Gesamtzusammensetzung, enthält.

15. Verfahren zur Herstellung einer Zusammensetzung nach Anspruch 2, bei dem
A) zumindest ein Initiator für die kationische Polymerisation in Form einer Oniumverbindung oder einer Verbindung der Formel (I) mit einem für ihn geeigneten Lösungs- oder Dispersionsmittel homogen vermischt wird,
B) zumindest ein Polymerisationsinhibitor, wie oben beschrieben, als Komponente c) mit dem kationisch polymerisierbaren organischen Material homogen vermischt wird,
C) die in den Schritten A) und/oder B) erhaltenen Teilmischungen gegebenenfalls zwischengelagert werden, und
D) die beiden Teilmischungen miteinander vermischt werden.

16. Verwendung einer Zusammensetzung nach Anspruch 2 zur Imprägnierung und Umhüllung von elektrischen Hoch- oder Niederspannungsbauteilen oder von elektronischen Bauteilen.

17. Verwendung einer Zusammensetzung nach Anspruch 2 als flüssiges oder festes Beschichtungsmittel.

18. Verwendung einer Zusammensetzung nach Anspruch 2 zur Herstellung von Epoxidniederdruckpressmassen (Low Pressure Molding Compounds).

19. Verwendung einer Zusammensetzung nach Anspruch 2 als Teil eines Composite-Systems für Leiterplatten oder als Matrix für Faserverbundstoffe.

20. Verwendung einer Zusammensetzung nach Anspruch 2 als heisshärtender Klebstoff.

## Claims

1. The use of an inhibitor for cationic polymerisation as an additive to a thermocurable composition based on at least one cationically polymerisable organic material and an initiator for cationic polymerisation in the form of an onium compound or a compound of the formula (I)
[M⁺ⁿ(L)ₓ]ⁿ⁺ n X⁻ (I),
in which n is 2 or 3, M is a metal cation selected from the group comprising Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ and Co³⁺, X⁻ is an anion selected from the group comprising PF₆⁻, AsF₆⁻, SbF₆⁻, BiF₆⁻, derivatives of these anions in which at least one fluorine atom has been replaced by a hydroxyl group, and CF₃SO₃⁻, or in which up to 50% of the anions X⁻, based on the total amount of anions, may be any desired anions, L is water or an organic σ-donor ligand which contains, as bonding sites, one or more functional radicals selected from the group comprising -CO-, -CO-O-, -O-CO-O- and -O- and forms σ-bonds with the central atom via the oxygen atom or atoms, and x is an integer from 0 to 6, and where the ligands L may be different within said definitions, or as an additive to components for the preparation of a composition of this type for avoiding initiator decomposition products which are formed due to moisture and reduce the thermal stability of the composition, and/or for increasing the thermal stability of the composition for a limited time before curing.

2. A thermocurable composition which comprises at least the following components:
a) a cationically polymerisable organic material,
b) an initiator for cationic polymerisation in the form of an onium compound or a compound of the formula (I)
[M⁺ⁿ(L)ₓ]ⁿ⁺ n X⁻ (I),
in which n is 2 or 3, M is a metal cation selected from the group comprising Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ and Co³⁺, X⁻ is an anion selected from the group comprising PF₆⁻, AsF₆⁻, SbF₆⁻, BiF₆⁻, derivatives of these anions in which at least one fluorine atom has been replaced by a hydroxyl group, and CF₃SO₃⁻, or in which up to 50% of the anions X⁻, based on the total amount of anions, may be any desired anions, L is water or an organic σ-donor ligand which contains, as bonding sites, one or more functional radicals selected from the group comprising -CO-, -CO-O-, -O-CO-O- and -O- and forms σ-bonds with the central atom via the oxygen atom or atoms, and x is an integer from 0 to 6, and where the ligands L may be different within said definitions,
c) a polymerisation inhibitor which by an acid/base reaction neutralizes the strong Brønstedt acids formed by the initiator compounds both in the course of thermal curing and during storage, owing to decomposition as a result of moisture or impurities, the amount of this inhibitor being so small that sufficient initiator b) unaffected by it remains to effect the desired curing of the composition.

3. A composition according to claim 2, in which component c) is a Brönsted base whose strength corresponds to a pKₐ value of from 2 to 12 (at 25°C in water).

4. A composition according to claim 2, in which component c) is an amine.

5. A composition according to claim 4, which contains a tertiary amine.

6. A composition according to claim 4, which contains an amine selected from the group comprising:
(c₁) aromatic amines containing one to four NH₂ groups and having at least one substituent in the ortho-position to each amino group, where the substituent is C₁-C₁₀alkyl, C₁-C₁₀alkoxy, C₅-C₆cycloalkyl, C₆-C₁₀aryl or halogen, with the proviso that the amine is not halogen-substituted in both ortho-positions to an amino group, and
(c₂) aromatic amines containing 1 to 4 NH₂ groups and having one ortho- or para-substituent to each amino group present, where the substituent is -COOH, -COOR, -COR, -SO₂R or -SOR, and R is C₁-C₁₀alkyl, C₅-C₆cycloalkyl, C₆-C₁₀aryl, aminoaryl or -R'-OOC-C₆H₄-NH₂ where R' is alkylene.

7. A composition according to claim 4, in which the amine has a pKₐ value of from 2 to 9.

8. A composition according to claim 2, in which the polymerisation inhibitor is present in an amount of from 0.01 to 0.5 equivalents, preferably from 0.01 to 0.15 equivalents, based on the onium groups in the initiator.

9. A composition according to claim 2, in which component a) is a difunctional or polyfunctional epoxy resin.

10. A composition according to claim 2, in which component b) is a sulfonium salt initiator.

11. A composition according to claim 10, in which the sulfonium salt initiator is a compound of the formula (IV), (V), (VI) or (VII): 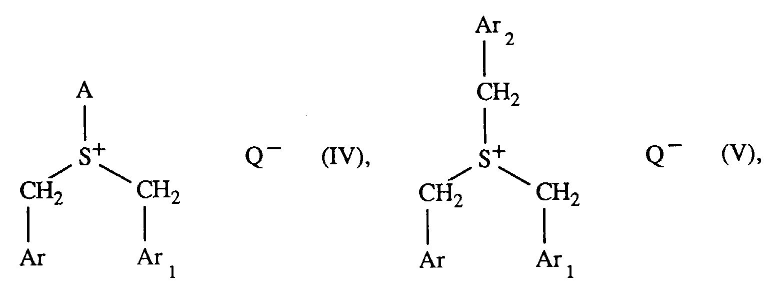 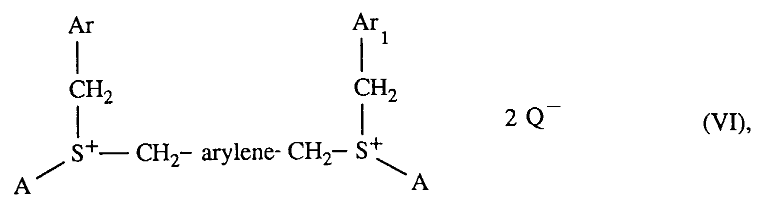 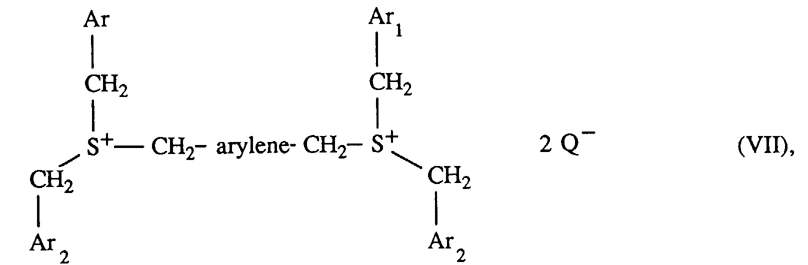 in which A is C₁-C₁₂alkyl, C₃-C₈cycloalkyl, C₄-C₁₀cycloalkylalkyl or phenyl which is unsubstituted or monosubstituted or polysubstituted by C₁-C₈alkyl, C₁-C₄alkoxy, halogen, hydroxyl, nitro, phenyl, phenoxy, alkoxycarbonyl having 1-4 carbon atoms in the alkoxy radical or acyl having 1-12 carbon atoms, Ar, Ar₁ and Ar₂, independently of one another, are each phenyl or naphthyl which is unsubstituted or monosubstituted or polysubstituted by C₁-C₈alkyl, C₁-C₄alkoxy, halogen, hydroxyl, nitro, phenyl, phenoxy, alkoxycarbonyl having 1-4 carbon atoms in the alkoxy radical or acyl having 1-12 carbon atoms, arylene is in each case phenylene or naphthylene which is unsubstituted or monosubstituted or polysubstituted by C₁-C₈alkyl, C₁-C₄alkoxy, halogen, hydroxyl, nitro, phenyl, phenoxy, alkoxycarbonyl having 1-4 carbon atoms in the alkoxy radical or acyl having 1-12 carbon atoms, and Q⁻ is SbF₆⁻, AsF₆⁻ or SbF₅OH⁻.

12. A composition according to claim 11, in which component b) is a sulfonium initiator of the formula (IV) or (V) in which A is C₁-C₁₂alkyl or phenyl which is unsubstituted or substituted by halogen or C₁-C₄alkyl, Ar, Ar₁ and Ar₂, independently of one another, are each phenyl which is unsubstituted or monosubstituted or polysubstituted by C₁-C₈alkyl, C₁-C₄alkoxy, Cl or Br, and Q⁻ is SbF₅OH⁻ or in particular ASF₆⁻ or SbF₆⁻.

13. A composition according to claim 2, in which the further component d) is a solvent or dispersing agent for the initiator.

14. A composition according to claim 2, in which aluminium oxide hydrate is present in an amount of from 50 to 70% by weight, based on the total composition.

15. A process for the preparation of a composition according to claim 2, in which
A) at least one initiator for cationic polymerisation in the form of an onium compound or a compound of the formula (I) is homogeneously mixed with a solvent or dispersing agent which is suitable for the initiator,
B) at least one polymerisation inhibitor, as described above, is homogeneously mixed as component c) with the cationically polymerisable organic material,
C) the submixtures obtained in steps A) and/or B) are, if desired, subjected to interim storage, and
D) the two submixtures are mixed with one another.

16. The use of a composition according to claim 2 for impregnating and encapsulating electrical high- or low-voltage components or electronic components.

17. The use of a composition according to claim 2 as a liquid or solid coating composition.

18. The use of a composition according to claim 2 for the preparation of low-pressure epoxy moulding compounds.

19. The use of a composition according to claim 2 as part of a composite system for circuit boards or as a matrix for fibre composites.

20. The use of a composition according to claim 2 as a heat-curing adhesive.

## Revendications

1. Utilisation d'un inhibiteur de polymérisation cationique comme additif à une composition thermodurcissable à base d'au moins une matière organique polymérisable par voie cationique et d'un amorceur de polymérisation cationique sous forme d'un composé d'onium ou d'un composé de formule (I)
[M⁺ⁿ(L)ₓ]ⁿ⁺ nX⁻ (I),
dans laquelle n vaut 2 ou 3, M est un cation de métal pris dans le groupe comportant Zn²⁺, Mg²⁺, Fe²⁺, Co²⁺, Ni²⁺, Cr²⁺, Ru²⁺, Mn²⁺, Sn²⁺, VO²⁺, Fe³⁺, Al³⁺ et Co³⁺, X⁻ est un anion pris dans le groupe comportant PF₆⁻, AsF₆⁻, SbF₆⁻, BiF₆⁻, des dérivés dérivant de ces anions dans lesquels au moins un atome de fluor est remplacé par un groupe hydroxyle, et CF₃SO₃⁻, ou dans lesquels jusqu'à 50 % des anions X⁻ par rapport à la quantité totale des anions peuvent être également des anions facultatifs, L est l'eau ou un ligand donneur σ organique, qui présente comme sites ligands un ou plusieurs radicaux fonctionnels pris dans le groupe comportant -CO-, -CO-O-, -O-CO-O- ou et qui forme, par l'intermédiaire de l'atome d'oxygène ou par l'intermédiaire des atomes d'oxygène, des liaisons σ avec l'atome central et x est un nombre entier de 0 à 6, les ligands L dans le cadre des définitions données peuvent être différents, ou comme additif aux constitutants pour la préparation d'une telle composition pour éviter la formation due à l'humidité de produits de décomposition de l'amorceur qui réduisent la stabilité thermique de la composition, et/ou pour augmenter la stabilité thermique des compositions qui est limitée dans le temps avant la durcissement.

2. Composition thermodurcissable qui contient au moins les constitutants suivants :
a) une matière organique polymérisable par voie cationique,
b) un amorceur pour la polymérisation cationique sous forme d'un composé d'onium ou d'un composé de formule (I)
[M⁺ⁿ(L)ₓ]ⁿ⁺ nX⁻ (I),
dans laquelle n vaut 2 ou 3, M est un cation de métal pris dans le groupe comportant Zn²⁺, Mg²⁺, Fe²⁺, Co²⁺, Ni²+, Cr²⁺, Ru²⁺, Mn²⁺, Sn²⁺, VO²⁺, Fe³⁺, Al³⁺ et Co³⁺, X⁻ est un anion pris dans le groupe comportant PF₆⁻, AsF₆⁻, SbF₆⁻, BiF₆⁻, des dérivés dérivant de ces anions, dans lesquels au moins un atome de fluor est remplacé par un groupe hydroxyle, et CF₃SO₃⁻, ou dans lesquels jusqu'à 50 % des anions X⁻ par rapport à la quantité totale des anions peuvent être également des anions facultatifs, L est l'eau ou un ligand donneur σ organique, qui présente comme sites ligands un ou plusieurs radicaux fonctionnels pris dans le groupe comportant -CO-, -CO-O-, -O-CO-O- ou -O-, et qui forme, par l'intermédiaire de l'atome d'oxygène ou par l'intermédiaire des atomes d'oxygène, des liaisons σ avec l'atome central et x est un nombre entier de 0 à 6, les ligands L dans le cadre des définitions données pouvant être différents,
c) un inhibiteur de polymérisation qui neutralise les acides de Brönstedt forts qui sont formés par les composés amorceurs au cours du durcissement thermique mais également au cours du stockage par décomposition suite à l'humidité ou à la présence d'impuretés, dans le sens d'une réaction acide/base, dans une quantité tellement faible qu'il reste une quantité d'amorceur b) suffisante sur laquelle il n'exerce pas d'influence pour mener à bien la réaction de durcissement désiré de la composition.

3. Composition selon la revendication 2, où l'on ajoute comme constitutant c) une base de Bronstedt, dont la force correspond à une valeur de pKa de 2 à 12 (à 25 °C dans l'eau).

4. Composition selon la revendication 2, qui contient en tant que constitutant c) une amine.

5. Composition selon la revendication 4, qui contient une amine tertiaire.

6. Composition selon la revendication 4, qui contient une amine prise dans le groupe :
(c₁) amines aromatiques avec un à quatre groupes NH₂ avec au moins un substituant en position ortho par rapport à chaque groupe amino, le substituant pouvant représenter alkyle en C₁-C₁₀, alcoxy en C₁-C₁₀, cycloalkyle en C₅-C₆, aryle en C₆-C₁₀ ou halogène, à la condition que l'amine ne soit pas substituée par halogène dans les deux positions ortho par rapport à un groupe amino, et
(c₂) amines aromatiques avec un à quatre groupes NH₂ avec un substituant en position ortho ou para par rapport à chaque groupe amino présent, les substituants représentant -COOH, -COOR, -COR, -SO₂R ou -SOR et R représente alkyle en C₁-C₁₀, cycloalkyle en C₅-C₆, aryle en C₆-C₁₀, aminoaryle ou -R'-OOC-C₆H₄-HN₂ avec R' égal à alkylène.

7. Composition selon la revendication 4, dans laquelle l'amine présente une valeur de pKa de 2 à 9.

8. Composition selon la revendication 2, dans laquelle l'inhibiteur de polymérisation est présent dans une quantité de 0,01 à 0,5, de préférence de 0,01 à 0,15 équivalent par rapport aux groupes d'onium dans l'amorceur.

9. Composition selon la revendication 2, qui contient en tant que constitutant a) une résine époxyde di- ou polyfonctionnelle.

10. Composition selon la revendication 2, qui contient en tant que constitutant b) un amorceur de type de sel de sulfonium.

11. Composition selon la revendication 10, qui contient en tant qu'amorceur de type de sel de sulfonium un composé de formules (IV), (V), (VI) ou (VII) : 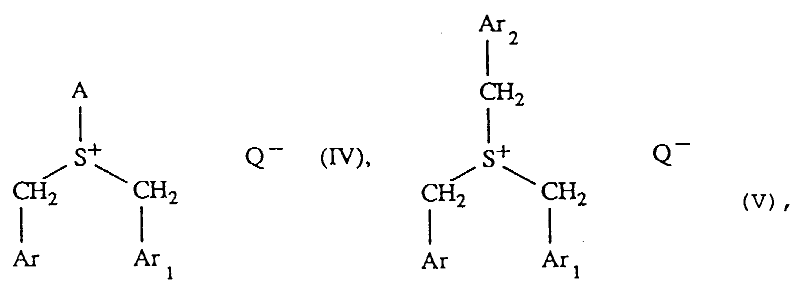 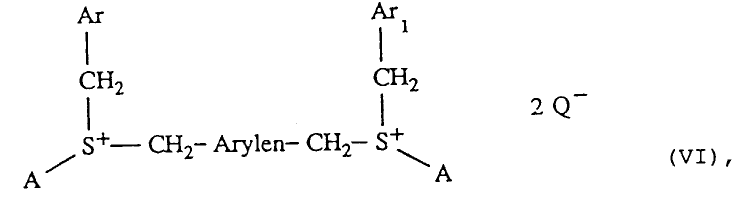 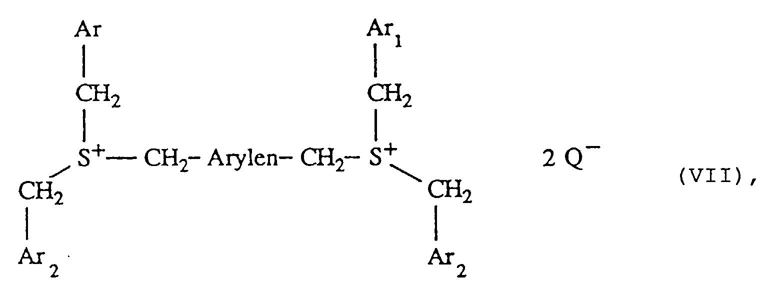 dans lesquelles A représente un alkyle en C₁-C₁₂, cycloalkyle en C₃-C₈, cycloalkylalkyle en C₄-C₁₀, phényle non substitué ou substitué une ou plusieurs fois par alkyle en C₁-C₈, alcoxy en C₁-C₄, halogéno, hydroxy, nitro, phényle, phénoxy, alcoxycarbonyle avec 1 à 4 atomes de carbone dans le radical alcoxy, ou par oe avec 1 à 12 atomes de carbone, Ar, Ar₁ et Ar₂, indépendamment les uns des autres, chacun représentent un radical naphtyle ou phényle non substitué ou substitué une ou plusieurs fois par alkyle en C₁-C₈, alcoxy en C₁-C₄, halogéno, hydroxy, nitro, phényle, phénoxy, alcoxycarbonyle avec 1 à 4 atomes de carbone dans le radical alcoxy, ou par acyle avec 1 à 12 atomes de carbone, arylène représente chaque fois naphtylène ou phénylène non substitué ou substitué une ou plusieurs fois par alkyle en C₁-C₈, alcoxy en C₁-C₄, halogéno, hydroxy, nitro, phényle, phénoxy, alcoxycarbonyle avec 1 à 4 atomes de carbone dans le radical alcoxy, ou par acyle avec 1 à 12 atomes de carbone, et Q⁻ représente SbF₆⁻, AsF₆⁻ ou SbF₅(OH)⁻.

12. Composition selon la revendication 11, qui contient en tant que constitutant b) un amorceur de type sulfonium de formule (IV) ou (V), où A représente un alkyle en C₁-C₁₂ Ou un phényle non substitué ou substitué par halogène ou alkyle en C₁-C₄, Ar, Ar₁ et Ar₂, indépendamment les uns des autres, sont chacun phényle non substitué ou substitué une ou plusieurs fois par alkyle en C₁-C₈, alcoxy en C₁-C₄, Cl ou Br, et Q⁻ représente SbF₅OH⁻, et plus particulièrement AsF₆⁻ ou SbF₆⁻.

13. Composition selon la revendication 2, qui contient en tant qu'autre constitutant d) un solvant ou un agent dispersant pour l'amorceur.

14. Composition selon la revendication 2, qui contient l'oxyde d'aluminium hydraté dans une quantité de 50 à 70 % en poids par rapport à la totalité de la composition.

15. Procédé pour la préparation d'une composition selon la revendication 2, dans laquelle
A) on mélange de façon homogène au moins un amorceur de polymérisation cationique sous forme d'un composé d'onium ou d'un composé de formule (I) avec un solvant ou agent dispersant approprié,
B) on mélange de façon homogène comme constitutant c) au moins un inhibiteur de polymérisation comme décrit ci-dessus, avec la matière organique polymérisable par voie cationique,
C) on stocke éventuellement de façon intermédiaire les mélanges partiels obtenus aux étapes A) et/ou B), et
D) on mélange les deux mélanges partiels.

16. Utilisation d'une composition selon la revendication 2, pour imprégnation et revêtement de composants électriques de haute et basse tension ou de composants électroniques.

17. Utilisation d'une composition selon la revendication 2, comme agent d'enduction liquide ou solide.

18. Utilisation d'une composition selon la revendication 2, pour la préparation de masse de moulage époxyde à basse pression (Low Pressure Molding Compounds).

19. Utilisation d'une composition selon la revendication 2, comme partie d'un système composite pour plaques de circuits imprimés ou comme matrice de matériaux composites fibreux.

20. Utilisation d'une composition selon la revendication 2, comme colle thermodurcissable.
